# EUROPEAN PATENT APPLICATION

(11) **EP 1 890 321 A1**
(43) Date of publication of application: **20.02.2008**
(21) Application number: 06732559.7
(22) Date of filing: 12.05.2006
(51) Int. Cl.: H01L 21/304, B24B 37/00, C09K 3/14

(54) **SEMICONDUCTOR ABRASIVE**

(30) Priority: 06.06.2005 JP 2005165768
(71) Applicant: Asahi Glass Company, Limited, Chiyoda-ku, Tokyo 100-8405 (JP); AGC Seimi Chemical Co., Ltd., Chigasaki-shi, Kanagawa 253-8585 (JP)
(72) Inventor: KON, Yoshinori, 1-chome, Chiyoda-ku, Tokyo 1008405 (JP); YOSHIDA, Iori, 1-chome, Chiyoda-ku, Tokyo 1008405 (JP); NAKAZAWA, Norihito, 1-chome, Chiyoda-ku, Tokyo 1008405 (JP)
(74) Representative: Müller-Boré & Partner Patentanwälte
(86) International application number: PCT/JP2006/309578
(87) International publication number: WO 2006/132055

(57) **Abstract**

To provide a semiconductor polishing compound which is excellent in dispersion stability and removal rate and which has a stabilized polishing property, as it is less susceptible to an influence even when contacted with an alkaline polishing compound during its application to CMP comprising a multistage process.

A polishing compound for chemical mechanical polishing to polish a surface to be polished in the production of a semiconductor circuit device, said polishing compound comprising cerium oxide abrasive particles, water and a dicarboxylic acid represented by the formula 1:

HOOC(CH₂)ₙCOOH Formula 1

wherein n is an integer of from 1 to 4, and the pH of said polishing compound at 25°C being within a range of from 3.5 to 6.

## Description

### TECHNICAL FIELD

The present invention relates to a semiconductor polishing compound for chemical mechanical polishing in a process for producing a semiconductor integrated circuit device. Particularly, it relates to a semiconductor polishing compound comprising cerium oxide, which is suitable for shallow trench isolation or planarization of an interlayer insulation film or a polysilicon.

### BACKGROUND ART

In recent years, micro-fabrication techniques have been developed for miniaturization and high densification along with high integration and high functionality of semiconductor integrated circuit devices. Particularly, importance of planarization techniques by chemical mechanical polishing (hereinafter referred to as CMP) is increasing.

For example, as miniaturization of semiconductor integrated circuit devices and multilayered structures of wirings progresses, the surface unevenness (difference in level) in each layer in the production process tends to increase. In order to prevent such a problem that this difference in level exceeds the depth of focus in photolithography so that no adequate resolution can be obtained, CMP has become an indispensable technique. Specifically, CMP is used for e.g. planarization of inter-level dielectrics (ILD), shallow trench isolation (STI), formation of a tungsten plug, or in a process for forming multilayered wirings comprising copper and low dielectric films.

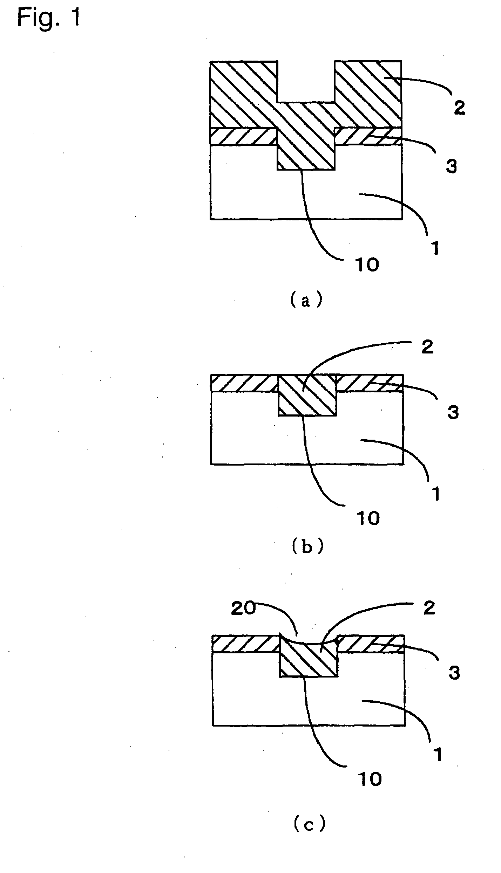

The STI process will be described with reference to Fig. 1. Fig. 1 (a) shows such a state that while an element region is masked with a silicon nitride film 3 or the like, a trench 10 is formed on a silicon substrate 1, and then an insulation film such as a silicon dioxide film 2 is deposited so that it is embedded in the trench 10. In this state, any excess silicon dioxide film 2 on the silicon nitride film 3 being a convex portion is polished and removed by CMP while the insulation film is permitted to remain in the trench 10 being a concave portion, thereby to obtain an element isolation structure having the insulation film embedded in the trench.
During CMP, it is common to use the silicon nitride film 3 by letting the removal rate of the silicon dioxide film and the removal rate of the silicon nitride film have a selective ratio, so that polishing is terminated at the time when the silicon nitride film 3 is exposed as shown in Fig. 1(b).

Here, if the polishing is excessive, the silicon dioxide film embedded in the trench 10 will be polished and recessed as shown in Fig. 1(c), whereby a structural defect such as a recess 20, so-called dishing, will result, and planarization tends to be inadequate or electrical performance tends to deteriorate. The degree of dishing depends on the width of the trench and the dishing tends to be large with a trench having a wide width.

Heretofore, silica abrasive particles have been common as abrasive particles to be used for CMP. However, the selective ratio between the removal rate of the silicon dioxide film and the removal rate of the silicon nitride film is small, and, in the STI process, it has become common to employ cerium oxide abrasive particles having excellent polishing selectivity between them. The cerium oxide polishing compound exhibits a high removal rate against a silicon dioxide film by a chemical reaction with the layer surface, and it is expected to improve the throughput in the process for producing a semiconductor device. Further, a technique is being developed to improve the dispersibility of the cerium oxide polishing compound and to improve planarization of the surface to be polished, by adding a surfactant, a water-soluble polymer, a water-soluble low molecular weight substance, etc. to such a cerium oxide polishing compound.

For example, Patent Document 1 discloses a technique whereby rather than a concave portion, a convex portion is preferentially polished for planarization by a polishing compound comprising cerium oxide abrasive particles and, as an additive, an organic compound containing hydrophilic groups such as carboxyl groups or carboxylate groups. Here, the additive is one to improve the trench width dependency of dishing, and in order to reduce dishing even with a wide trench, it is necessary that the concentration of the above additive is high. However, if the concentration of the additive is increased, agglomeration of cerium oxide particles will be accelerated, whereby sedimentation of abrasive particles will result, and the dispersion stability of the polishing compound tends to deteriorate. Further, if agglomeration of particles takes place, scratches will increase, thus leading to a problem that the integrated circuit device tends to be defective.

For example, Patent Document 1 discloses Examples for a polishing compound solution comprising pure water, and, as abrasive particles, 1% of cerium oxide and, as an additive, 6.0% of ammonium polycarboxylate, based on the total mass of the polishing solution. However, since the additive is at a high concentration, agglomeration of the abrasive particles is remarkable, and when the polishing solution is left to stand, cerium oxide abrasive particles will be completely sedimented within a few minutes. In the polishing process of CMP, there is a waiting time during which no polishing is carried out, and sedimentation of abrasive particles is likely to result at a portion where the polishing compound is not always stirred or moved, thus causing clogging of the pipeline.

In order to prevent such sedimentation, there is a method of incorporating an additive to the polishing compound on a polishing pad or in a pipeline immediately before the polishing pad, but the mixing tends to be inadequate, the concentration tends to be non-uniform, or the polishing characteristics tend to be unstable. Further, the abrasive particles on the pad tend to be agglomerated or deposited, whereby there has been a problem that scratches will increase.

Further, cerium oxide particles have a large specific gravity and thus tend to be readily sedimented, while they are superior in the polishing property to conventional silica particles. Further, they have a serious problem that if an additive to improve the polishing property is incorporated excessively, agglomeration will be accelerated, whereby sedimentation by agglomeration tends to be remarkable.

Patent Document 2 discloses, as a polishing compound useful for the STI process, a polishing compound comprising cerium oxide particles, water and an anionic surfactant, which is preferably a polishing compound falling within a regional range defined by four points i.e. point A (5.5, 0.9), point B (5.5, 3.0), point C (10.0, 3.0) and point D (9.0, 0.9), as represented by a (x, y) coordinate, wherein x is the pH, and y is the viscosity (mPa·s). And, it is disclosed that in order to realize global planarization, it is necessary to adjust the amount of the surfactant and the pH within such ranges that a polishing characteristic whereby the removal rate at a concave portion of a pattern is sufficiently small as compared with the removal rate at a convex portion, can be obtained, and the viscosity of the polishing compound is preferably from 1.0 to 2.5 mPa·s, particularly preferably from 1.0 to 1.4 mPa·s.

Further, it is disclosed that the viscosity will increase as the amount of the surfactant increases, and in order to realize a planarization characteristic with little pattern dependency by adjusting the viscosity within a range of from 1.0 to 1.4 mPa·s, the pH of the polishing compound after incorporation of the surfactant is preferably from 5.5 to 9, particularly preferably from 6 to 8.5, and within this pH range, the selective ratio between the removal rate of the silicon dioxide film and the removal rate of the silicon nitride film, can be made large. Further, it is exemplified to preliminarily incorporate a very small amount of a dispersant to the abrasive particles.

However, if a polishing compound is prepared in accordance with Examples given in Patent Document 2, when a surfactant is added to a dispersion of abrasive particles, the abrasive particles will be agglomerated to have an average particle diameter which is from 2 to 3 times the average particle diameter in the dispersion of particles. Accordingly, the dispersibility of abrasive particles in the polishing compound was poor, and the abrasive particles were sedimented within a few minutes, whereby it was difficult to use such a polishing compound, and the removal rate was also inadequate. Further, in a case where the concentration of the surfactant is high, dishing fluctuation is small, and the planarization characteristic is excellent. However, with a polishing compound prepared in accordance with an Example wherein the concentration of the surfactant is lower, dishing fluctuation was substantial, and the planarization characteristic was poor.

Further, if the concentration of the surfactant becomes high, the number of scratches sharply increases. This is believed to be attributable to that if the concentration of the surfactant is high, agglomeration and sedimentation of cerium oxide particles are accelerated, and they are accumulated on the polishing pad. Namely, it is considered that if coarse particles causing scratches, are present in abrasive particles even slightly, the particles will be agglomerated and accumulated on the polishing pad thereby to cause an increase of scratches. Further, it is also considered that there may be a case where agglomerates of abrasive particles grown by agglomeration themselves will cause scratches.

As described in the foregoing, in the prior art, no polishing compound was available which had both dispersion stability of the polishing compound and excellent scratch characteristics, and excellent polishing planarization characteristics, and it was difficult to obtain a semiconductor integrated circuit device having adequate properties. On the other hand, Patent Document 3 proposes a polishing compound comprising a soluble cerium, a pH buffering agent and abrasive particles and having a pH of from 3 to 11, and by using this polishing compound, it is possible to increase the selective ratio in the removal rate between a silicon dioxide film and a silicon nitride film. However, there has been a problem that by this method, cerium ions contained in the polishing compound will remain on a substrate and will present an adverse effect to the integrated circuit device.

In order to solve the above problems, we have proposed a polishing compound comprising cerium oxide abrasive particles, water and at least one additive selected from the group consisting of a water-soluble organic polymer and an anionic surfactant and having a pH of from 3.5 to 6, in Patent Document 4. This polishing compound has merits such that when it is used for the STI process, it is possible to obtain excellent polishing planarization characteristics with little dishing fluctuation, to shorten the polishing time of a patterned wafer and to reduce scratches. However, in a case where CMP is carried out by a multistage process wherein the polishing compound of Patent Document 4 is used in combination with another alkaline compound (slurry), it has been likely that the pH changes by the influence of the alkaline polishing compound, which may adversely affect the polishing properties. In particular, in Patent Document 4, the pH is adjusted by nitric acid to be within a range of from 3.5 to 6, but, it has been likely that, for example, ammonia evaporated from the alkaline polishing compound is absorbed by the polishing compound of Patent Document 4, or the alkaline polishing compound used in the first stage process will remain on the wafer surface and will be mixed with the polishing compound of Patent Document 4, whereby the pH will be changed to present an influence over the polishing properties.
Patent Document 1: Japanese Patent 3,278,532
Patent Document 2: JP-A-2000-160137
Patent Document 3: JP-A-2001-507739
Patent Document 4: WO04/010487

### DISCLOSURE OF THE INVENTION

### PROBLEMS WHICH THE INVENTION IS TO SOLVE

Under the circumstances, it is an object of the present invention to solve the above-mentioned problems and to provide a semiconductor polishing compound which is excellent in dispersion stability and removal rate and which has a stabilized polishing property, as it is less susceptible to an influence even when contacted with an alkaline polishing compound during its application to CMP comprising a multistage process.

### MEANS TO SOLVE THE PROBLEMS

Namely, The present invention provides the following:
(1) A semiconductor polishing compound which is a polishing compound for chemical mechanical polishing to polish a surface to be polished in the production of a semiconductor circuit device, said polishing compound comprising cerium oxide abrasive particles, water and a dicarboxylic acid represented by the formula 1:

   HOOC(CH₂)ₙCOOH Formula 1

   wherein n is an integer of from 1 to 4, and the pH of said polishing compound at 25°C being within a range of from 3.5 to 6.
(2) The semiconductor polishing compound according to the above (1), wherein the pH is within a range of from 4 to 6.
(3) The semiconductor polishing compound according to the above (1) or (2), wherein the absolute value of the difference between the pKa value of said dicarboxylic acid and said pH is at most 1.0.
(4) The semiconductor polishing compound according to any one of the above (1) to (3), wherein the dicarboxylic acid is at least one member selected from the group consisting of malonic acid, succinic acid and adipic acid.
(5) The semiconductor polishing compound according to any one of the above (1) to (4), wherein the concentration of the dicarboxylic acid is from 0.01 to 0.5 mass%.
(6) The semiconductor polishing compound according to any one of the above (1) to (5), wherein the surface to be polished is made of silicon dioxide.
(7) The semiconductor polishing compound according to any one of the above (1) to (6), which contain at least one additive selected from the group consisting of a water-soluble organic polymer and an anionic surfactant.
(8) The semiconductor polishing compound according to the above (7), wherein the water-soluble organic polymer is a polyacrylic acid or an ammonium polyacrylate.

### EFFECTS OF THE INVENTION

The semiconductor polishing compound of the present invention is not only excellent in dispersion stability and removal rate but also capable of exhibiting a stabilized polishing property, as it is less susceptible to an influence even when contacted with an alkaline polishing compound, particularly when contacted with ammonia evaporated from an alkaline polishing compound, in a multistage process.

### BRIEF DESCRIPTION OF DRAWINGS

Fig. 1 is a schematic cross-sectional view illustrating a process for polishing a semiconductor device substrate by a semiconductor polishing compound.
Fig. 2 is a diagrammatic view showing an example of a polishing apparatus to which the polishing compound of the present invention is applicable.
Fig. 3 is a schematic sectional side view of a blanket wafer.
Fig. 4 is a graph showing an interrelation between the concentration of ammonia added to the polishing compounds in Examples 1 to 5 of the present invention and the removal rate.

### MEANINGS OF SYMBOLS

1: silicon substrate
2: silicon dioxide film
3: silicon nitride film
10: trench
20: dishing
31: semiconductor device
32: polishing head
33: polishing plate
34: polishing pad
35: polishing compound-supplying pipe
36: polishing compound

### BEST MODE FOR CARRYING OUT THE INVENTION

Now, the present invention will be described in detail.

In the present invention, cerium oxide is used as abrasive particles. Heretofore, it has been known that cerium oxide abrasive particles show a specifically high removal rate in polishing of a glass type material including a silicon dioxide film. Namely, when cerium oxide is in contact with a silicon dioxide film in the surface to be polished, a chemical bond will be formed between the two, which creates a grinding power higher than the mere mechanical action. Accordingly, in polishing by means of cerium oxide, it is important to control the contact of the abrasive particles with the surface to be polished. Here, in this invention, "the surface to be polished" means an intermediate stage surface which appears in the process for producing a semiconductor device.

In a STI process or a CMP process for an interlayer dielectric film, it is desired to efficiently planarize the surface to be polished such as a silicon dioxide film having surface unevenness. Namely, it is preferred to selectively polish convex portions. To realize such selective polishing, it is advisable to incorporate in the polishing compound an additive which is to be adsorbed on the surface of cerium oxide abrasive particles to prevent direct contact with the surface to be polished such as a silicon dioxide film thereby to control polishing. By incorporating such an additive, if a high pressure is exerted, the additive adsorbed on the surface of cerium oxide abrasive particles, will be peeled off to cause the contact with the surface to be polished, whereby polishing will proceed.

In a common polishing method wherein a surface to be polished is pressed against e.g. a polishing pad and relatively moved, the pressure exerted to the surface to be polished differs locally depending upon the surface contour. At a convex portion, the pressure exerted will be high as compared with at a concave portion. Accordingly, at the convex portion, the additive adsorbed on the surface of cerium oxide abrasive particles is likely to be peeled off to readily form the contact with the surface to be polished thereby to facilitate the polishing, and thus, it becomes possible to selectively polish the convex portion against the concave portion.

The cerium oxide surface in an aqueous dispersion is positively charged within a range of from neutral to acidic, and as the additive, a water-soluble organic polymer or an anionic surfactant is preferred. As the water-soluble organic polymer, a polymer having carboxylic acid groups or ammonium carboxylate groups (-COONH₄) is preferred.

Further, in the STI process, usually, selectivity is given between the removal rates of the silicon oxide film and the silicon nitride film, so that the silicon nitride film is used as a stopper. In an aqueous dispersion medium, the surface of the silicon dioxide film is negatively charged, and the surface of the silicon nitride film is positively charged, within a range of from neutral to acidic (about pH 3), whereby the above-mentioned anionic additive will selectively be adsorbed on the surface of the silicon nitride film. Therefore, contact of the silicon nitride film with the cerium oxide abrasive particles will be prevented thereby to provide selectivity between the removal rates of the silicon dioxide film and the silicon nitride film.

With a conventional semiconductor polishing compound, as mentioned above, in order to selectively polish convex portions and to provide selectivity between the removal rates of the silicon dioxide film and the silicon nitride film, it has been believed desirable that the concentration of the above-mentioned additive is within a range of from 2 to 3%, and the pH of the polishing compound is at a level of from 7 to 8 i.e. in the vicinity of neutral. However, under these conditions, agglomeration of abrasive particles by the additive has been remarkable, and the dispersion stability of abrasive particles has been inadequate although the planarization characteristics by polishing may be excellent.

As a result of an extensive study, the present inventors have found that by selecting the pH range of the polishing compound, it is possible to improve the planarization characteristics by polishing even when the amount of the additive in the polishing compound is reduced, and further it is possible to increase the dispersion stability of abrasive particles in the polishing compound, and thus have arrived at the present invention. In the semiconductor polishing compound of the present invention, the concentration of the additive is preferably from 0.01 to 0.5% (mass ratio) based on the total mass of the polishing compound. However, with such a concentration range, it has heretofore been considered that the concentration of the additive is too low and inadequate to provide the necessary polishing characteristics. However, if the pH of the polishing compound is within a range of from 3 to 7, it is possible to provide adequate polishing characteristics at a concentration of the additive lower than before. Further, if the concentration of the additive is reduced, agglomeration of abrasive particles by the additive tends to scarcely occur, whereby the dispersion stability will be improved, and it will be possible to simultaneously satisfy the planarization characteristics by polishing and the dispersion stability of abrasive particles.

Within the pH range in the present invention, as compared with in the vicinity of neutral, the positive potential on the cerium oxide surface will increase, whereby the additive tends to be readily adsorbed on the cerium oxide surface. Further, in a case where the negative charge of the additive is substantial, due to the electrical repulsion of the additive particles among themselves, the additive tends to be hardly adsorbed in multilayers on the cerium oxide surface. However, in this pH range, the degree of dissociation of the additive itself will be small, and the negative charge will be small, whereby multiple adsorption will be possible. Further, in a case where a water-soluble organic polymer having carboxylic acid groups, is, for example, used as the additive, if the water-soluble organic polymer is not dissociated, the water-soluble organic polymer particles among themselves tend to be entangled by the hydrogen bonds on the cerium oxide surface, and they tend to be adsorbed in multilayers. Therefore, in the pH range in the present invention, even if the additive concentration is low, the additive will adequately be adsorbed on the surface of cerium oxide abrasive particles, whereby polishing planarization characteristics can be provided.

The pH of the polishing compound of the present invention is from 3.5 to 6, particularly preferably from 4 to 6. If the pH is lower than 3.5, the amount of the additive to be adsorbed on the surface of the silicon nitride film tends to be extremely small, whereby the surface protection of the silicon nitride film tends to be inadequate. Further, the electric charge of the additive will be small, whereby the adsorbability of the additive to the cerium oxide abrasive particles will be weakened. Further, the electric charge of the additive adsorbed on the cerium oxide surface will also be small, whereby the electrical repulsion will decrease, and the dispersion stability of the polishing compound tends to deteriorate. Inversely, if the pH exceeds 6, a large amount of the additive will be required to provide the planarization characteristics, whereby the dispersibility of the cerium oxide abrasive particles tends to be poor, whereby agglomeration and sedimentation of the polishing compound tend to proceed.

In the present invention, the cerium oxide abrasive particles are not particularly limited, but, for example, cerium oxide abrasive particles disclosed in JP-A-11-12561 or JP-A-2001-35818 may preferably be used. Namely, a cerium oxide powder obtained by adding an alkali to an ammonium aqueous solution of cerium (IV) nitrate to prepare a cerium hydroxide gel, followed by filtration, washing and firing, may preferably be used. Further, cerium oxide abrasive particles obtained by milling and firing cerium carbonate of high purity, followed by further milling and classification, may also preferably be used.

The average particle diameter of the cerium oxide abrasive particles is preferably from 0.05 to 0.5 µm, particularly preferably from 0.1 to 0.3 µm, further preferably from 0.1 to 0.2 µm. If the average particle diameter is too large, abrasion flaws such as scratches are likely to be formed on the surface of the semiconductor substrate. On the other hand, if the average particle diameter is too small, the removal rate tends to be low. Further, as the proportion of the surface area per unit volume is large, the polishing compound is susceptible to the influence of the surface condition, and depending upon the conditions such as the pH and the concentration of the additive, the polishing compound may tend to be agglomerated.

For the measurement of the average particle diameter, a particle size distribution meter of e.g. laser diffraction-scattering type, dynamic light scattering type or photon correlation type, may be used. In a case where the particle diameter is large to some extent and the particles are likely to be sedimented, it is preferred to use a laser diffraction-scattering type particle size distribution meter, and the above-mentioned range is a preferred range in a case where the average particle diameter is measured by using a laser diffraction-scattering type particle size distribution meter.

The additive in the present invention is at least one member selected from the group consisting of a water-soluble organic polymer and an anionic surfactant. The water-soluble organic polymer is preferably one having carboxylic acid groups or carboxylate groups. It may specifically be a homopolymer of a monomer having a carboxylic acid group such as acrylic acid, methacrylic acid or maleic acid, or a homopolymer corresponding to such a homopolymer wherein the carboxylic acid group portions are in the form of salts such as ammonium salts. Further, a copolymer of a monomer having a carboxylic acid group with a monomer having a carboxylate group, or a copolymer of a monomer having a carboxylate group with a derivative of a carboxylic acid such as an alkyl ester thereof, is also preferred. Further, a water-soluble organic polymer such as a polyvinyl alcohol, or an anionic surfactant such as ammonium oleate, ammonium lauryl sulfate or triethanolamine lauryl sulfate, may also suitably be used.

Particularly preferred is a polymer having carboxylic acid groups or carboxylate groups. Specifically, it may, for example, be a polyacrylic acid or a polymer having at least some of carboxylic acid groups in a polyacrylic acid substituted by ammonium carboxylate groups (hereinafter referred to as an ammonium polyacrylate).

Here, in a case where a water-soluble organic polymer such as an ammonium polyacrylate is used as the additive, its molecular weight is preferably from 1,000 to 50,000, particularly preferably from 2,000 to 30,000.

The present inventors have conducted an extensive study and as a result, have found that by using a dicarboxylic acid represented by the formula 1 as a pH-controlling agent for the polishing compound, it is possible to obtain a polishing compound capable of providing a stabilized polishing characteristics, as it is less susceptible to an influence by contact with ammonia evaporated from an alkaline polishing compound or by contact with an alkaline polishing compound for the first stage process remaining on a wafer surface, as compared with a conventional polishing compound containing an inorganic acid or an inorganic acid salt commonly used as a pH-controlling agent, and thus arrived at the present invention. This is considered attributable to the fact that pKa of the carboxylic acid is in the vicinity of 5, whereby an adequate pH-buffering performance is provided. Among dicarboxylic acids represented by the formula 1, it is particularly preferred to employ at least one member selected from the group consisting of malonic acid (n=1), succinic acid (n=2) and adipic acid (n=4), whereby the effect for stabilizing the polishing characteristics can be made high.

HOOC(CH₂)ₙCOOH Formula 1

Here, when the absolute value of the difference between the pKa value of the dicarboxylic acid represented by the formula 1 and the pH of the polishing compound is preferably at most 1.0, it is possible to obtain a polishing compound having high pH-buffering effects and stabilized polishing characteristics. In order to further increase the pH-buffering effects, it is preferred to adjust the absolute value of the above difference to be at most 0.5. Here, pKa₂ of malonic acid is 5.28, pKa₂ of succinic acid is 5.24, pKa of glutaric acid (n=3) is 5.01, and pKa₂ of adipic acid is 5.03, and by suitably selecting the dicarboxylic acid of the formula 1, it is possible to obtain desired polishing characteristics.

As the polishing compound of the present invention, in view of the long term storage stability or the reliability of various polishing characteristics, it is preferred to prepare a semiconductor polishing compound by preparing liquid 1 comprising cerium oxide abrasive particles and water, and liquid 2 comprising the additive and water, and mixing liquids 1 and 2 prior to the polishing. The method for mixing liquids 1 and 2 may be a method of mixing them on a polishing pad or in a pipeline immediately before the polishing pad. However, the semiconductor polishing compound of the present invention undergoes substantially no agglomeration even after such mixing and is stable for a practically sufficient period of time, and therefore they may be preliminarily be mixed. Namely, a commonly employed semiconductor polishing compound-supplying system may be utilized whereby liquids 1 and 2 are put into a polishing compound storage tank and stirred and mixed by a propeller stirring machine, or the polishing compound may be continuously moved by a circulation line. Further, it is also possible to employ a polishing compound prepared by preliminarily mixing liquids 1 and 2 at a plant for producing the semiconductor polishing compound of the present invention. In such a case, depending upon the period for storage without stirring, abrasive particles may settle by gravity, and therefore, it is advisable to thoroughly stir it to redisperse the settled abrasive particles before use.

In the present invention, in order to sufficiently mix the cerium oxide abrasive particles and the additive and to stabilize the adsorbed state of the additive on the particle surface, it is preferred to preliminarily mix and stir liquid 1 comprising the cerium oxide particles and water with liquid 2 comprising the additive and water and then use the obtained polishing compound. The polishing compound may be used immediately after mixing liquids 1 and 2, but it is preferred to use it at least a few minutes after the mixing. It is particularly preferred to use the polishing compound upon expiration of at least 15 minutes after the mixing. By supplying the semiconductor polishing compound prepared by mixing, via a pump, to a polishing apparatus, it is possible to carry out CMP polishing constantly. To the supply line, a circulation line may be provided for uniformity of the semiconductor polishing compound.

For the preparation of liquid 1, it is preferred to employ a method of dispersing cerium oxide abrasive particles in pure water or deionized water, and at the time of dispersion, it is preferred to employ an ultrasonic disperser whereby agglomerates are disintegrated by the energy of ultrasonic waves to disperse abrasive particles in water, or a homogenizer, or Ultimizer (tradename, manufactured by Sugino Machine) or Nanomizer (tradename, manufactured by Yoshida Kikai Co., Ltd.) whereby agglomerates are disintegrated by the collision kinetic energy by collision of abrasive particles one another to disperse abrasive particles in water. Further, it is also preferred to simultaneously add a dispersant at that time. Here, the dispersant is one to be added to stably disperse abrasive particles in a dispersing medium such as pure water, and as such a dispersant, the same one as the above-described additive may be used. Namely, the additive in the present invention may be added not only to liquid 2 but also to liquid 1 as one having a function as a dispersant.

When a dispersant is to be added to liquid 1, its concentration is preferably within a range of from 0.1 to 1.0%, more preferably from 0.3 to 0.7%, by a mass ratio to the mass of the cerium oxide abrasive particles. If the concentration of the dispersant is lower than this concentration range, the dispersibility of abrasive particles tends to be inadequate, and if the concentration of the dispersant is higher than this range, agglomeration of abrasive particles tends to gradually proceed.

For the preparation of liquid 2, a method of dissolving the above-described additive to pure water or deionized water, may, for example, be mentioned. Further, by incorporating a dicarboxylic acid of the formula 1 to liquid 2 to preliminarily carry out the pH adjustment, it is possible to bring the pH of the semiconductor polishing compound to be prepared by mixing liquids 1 and 2, to a predetermined level. Further, as a method of bringing the pH of the semiconductor polishing compound after the mixing to the predetermined level, a method of controlling the pH of the above additive, may also be employed. For example, in a case where a copolymer made of a carboxylic acid with a carboxylate, is used as the additive, it is possible to employ a method of adjusting the pH by controlling the polymerization ratio of the carboxylic acid with the carboxylate.

HOOC(CH₂)ₙCOOH Formula 1

The concentrations of liquids 1 and 2 may, for example, be made to be twice the concentration at the time of use for polishing, so that the prescribed concentration may be obtained by mixing liquids 1 and 2 in a mass ratio of 1:1. Further, for the sake of convenience for storage or transportation, the concentrations of liquids 1 and 2 may, for example, be made so that the concentrations of the components such as the abrasive particles, the additive, etc. would be about ten times the concentration at the time of use for polishing, and they are diluted to a concentration of twice at the time of use, and liquids 1 and 2 are further mixed in a mass ratio of 1:1 to obtain the prescribed concentration. Further, liquids 1 and 2 having concentrations of ten times and deionized water may be mixed in a mass ratio of 1:1:8 to obtain the prescribed concentration. However, the method for adjusting the concentration is not limited to such specific methods.

The method for preparing the polishing compound of the present invention is not limited to the above-described method of dividing into liquids 1 and 2, followed by mixing. For example, cerium oxide abrasive particles, the dicarboxylic acid of the formula 1 and, if necessary, an additive, may be added to water, followed by mixing to prepare the polishing compound.

HOOC(CH₂)ₙCOOH Formula 1

As the semiconductor substrate to be polished by the semiconductor polishing compound of the present invention, the above-mentioned STI substrate for shallow trench isolation may be mentioned as a preferred example. As described above, the semiconductor polishing compound of the present invention has high selectivity for the removal rate against a silicon dioxide film and a silicon nitride film and is capable of polishing a silicon dioxide film at a high removal rate with no substantial dishing. Thus, the polishing compound of the present invention is effective for polishing a semiconductor substrate having a silicon dioxide film 2 and a silicon nitride film 3 formed on a silicon substrate 1. Further, as an application, the polishing compound of the present invention is effective also for polishing for planarization of an interlayer insulation film between multilayer wirings or for planarization of a polysilicon.

The silicon dioxide film 2 may, for example, be a so-called PE-TEOS film formed by a plasma CVD method using tetraethoxysilane as starting material. Further, a so-called HDP film formed by a high density plasma CVD method may also be mentioned. The silicon nitride film 3 may, for example, be one formed by a low pressure CVD method or a plasma CVD method using silane or dichlorosilane and ammonia as starting materials.
Further, instead of the silicon dioxide film, a SiOF film, a BPSG (Boro-Phospho-Silicate Glass) film or a PSG (Phospho-Silicate Glass) film may, for example, be also used. Further, instead of the silicon nitride film, a SiON film or a SiCN film may, for example, be used.

When a semiconductor substrate is polished by means of the polishing compound of the present invention, the polishing compound is supplied to a polishing pad, the surface to be polished, of the semiconductor device, is brought in contact with the polishing pad, and the surface to be polished, of the silicon dioxide material layer is polished by relative motion between them. Here, the conditions with respect to the silicon dioxide material, are the same as described in connection with the polishing compound of the present invention.

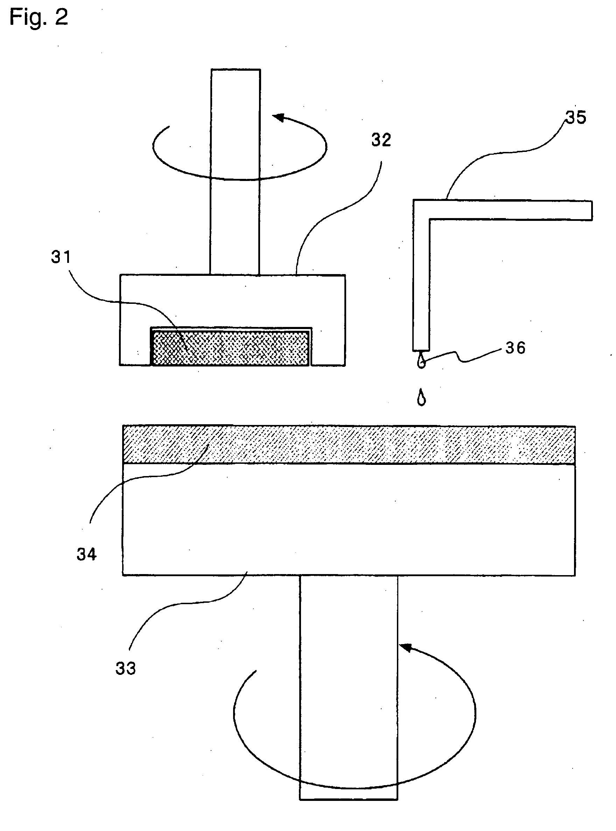

As the polishing apparatus, a common polishing apparatus may be used. For example, Fig. 2 is a view showing an example of a polishing apparatus which can be used for the polishing method of the present invention. This is a system wherein while the semiconductor polishing compound 36 is supplied from a polishing compound-supply pipe 35, a semiconductor device 31 is held by a polishing head 32 and is brought in contact with a polishing pad 34 bonded to the surface of a polishing table 33, and the polishing head 32 and the polishing table 33 are rotated for relative movement. However, the polishing apparatus of the present invention is not limited thereto.

The polishing head 32 may perform not only rotational but also a linear movement. The polishing table 33 and the polishing pad 34 may be of the same size as or smaller than the semiconductor device 31. In such a case, it is preferred to relatively move the polishing head 32 and the polishing table 33, so that the entire surface of the semiconductor device can be polished. Otherwise, the polishing table 33 and the polishing pad 34 may not be of a rotational type, but may for example be of a type moving in one direction by a belt system.

The polishing conditions of the polishing apparatus are not particularly limited, but the removal rate can be improved by exerting a load to the polishing head 32 to press it against the polishing pad 34. The polishing pressure at that time is preferably at a level of from 0.5 to 50 kPa, and from the viewpoint of the uniformity of the removal rate within the semiconductor device, flatness and prevention of polishing defects such as scratches, it is particularly preferably at a level of from 3 to 40 kPa. Further, the rotational speeds of the polishing table and the polishing head are preferably from about 50 to 500 rpm, but not limited thereto.

The polishing pad may be one made of e.g. a common non-woven fabric, a foamed polyurethane, a porous resin or a non-porous resin. Further, lattice, concentric or helical grooves may be formed on the surface of the polishing pad in order to promote the supply of the semiconductor polishing compound or to let a certain amount of the semiconductor polishing compound stay there.

### EXAMPLES

Now, Examples of the present invention will be described. Examples 1 to 3 are Examples of the present invention, and Examples 4 and 5 are Comparative Examples. In Examples, "%" means "mass%" unless otherwise specified. The property values were evaluated by the following methods. pH

Measured by pH81-11, manufactured by Yokogawa Electric Corporation.

### AVERAGE PARTICLE DIAMETER OF ABRASIVE PARTICLES

Measured by using a laser scattering-diffraction apparatus (tradename: LA-920, manufactured by HORIBA, LTD.).

### DISPERSION STABILITY OF POLISHING COMPOUND

With respect to "Time for agglomeration and sedimentation" in Examples, 20 mL of a polishing compound was put in a glass test tube having a diameter of 18 mm and left to stand still for 10 days, whereby it was obtained as a time until the polishing compound was separated into two layers to form a supernatant.

### POLISHING CHARACTERISTICS

### (1) Polishing conditions

Polishing was carried out by the following apparatus under the following conditions.

Polishing machine: Fully automatic CMP apparatus MIRRA (manufactured by APPLIED MATERIALS)

Polishing compound-supplying rate: 200 mL/min

Polishing pad: K-groove of double layer pad IC-1400, or K-groove of single layer pd IC-1000 (manufactured by Rodel)

Conditioning of polishing pad: MEC100-PH3.5L (manufactured by Mitsubishi Material)

Rotational speed of polishing plate: 77 rpm

Rotational speed of polishing head: 73 rpm

Polishing pressure: 27.5 kPa

### (2) Object to be polished

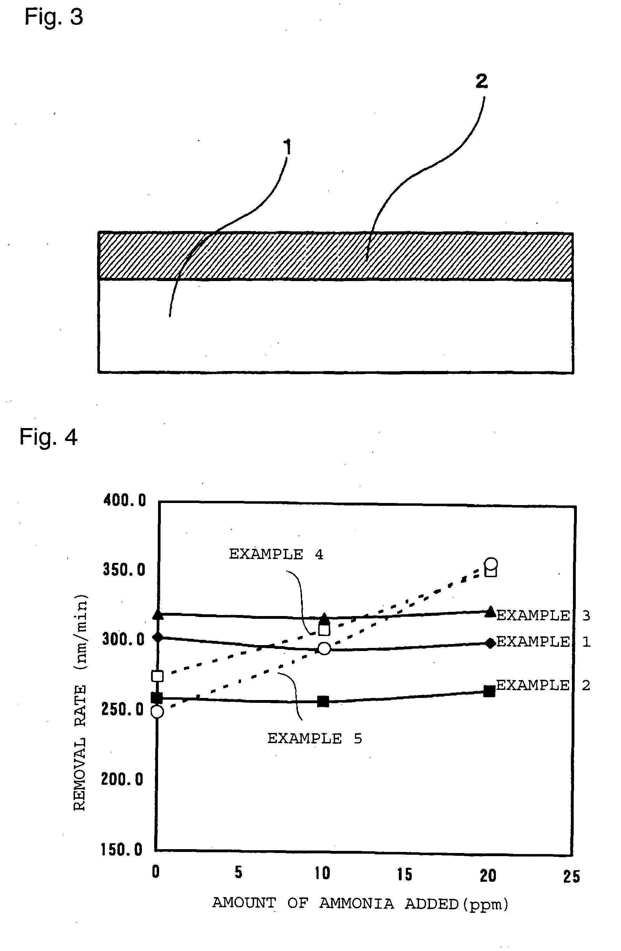

HDP silicon dioxide film-coated blanket wafer manufactured by Advance Materials Technology, was used as an object to be polished. A schematic sectional side view of the blanket wafer is shown in Fig. 3.

### (3) Method for evaluation of properties

The above blanket wafer was polished for 60 seconds, whereby the difference in the film thickness between before and after the polishing was taken as the removal rate. For measurement of the film thickness, an optical interfero type fully automatic measuring apparatus UV-1280SE (manufactured by KLA-Tencor) was used.

### EXAMPLE 1

Cerium oxide abrasive particles and, as an additive, an ammonium polyacrylate having a molecular weight of 5,000 were mixed in a mass ratio of 100:0.7 in deionized water with stirring, and subjected to ultrasonic dispersion and filtering to obtain a mixture having a concentration of abrasive particles of 10% by mass ratio and a concentration of the additive of 0.07%. This mixture was diluted five times with deionized water to prepare an abrasive particle mixed liquid A having an abrasive particle concentration of 2% and an additive concentration of 0.014%. The abrasive particle mixed liquid A had a pH of 7.6 and an average particle diameter of 0.18 µm.

Then, an ammonium polyacrylate having a molecular weight of 5,000 was dissolved in deionized water, and the pH adjustment was carried out by adding malonic acid (pKa₂=5.28) to bring the pH to from 4.7 to 5.0, to prepare an additive liquid B having an ammonium polyacrylate concentration of 0.289% and a malonic acid concentration of 0.166%.

The abrasive particle mixed liquid A and the additive liquid B were mixed in a mass ratio of 1:1 with stirring to prepare a polishing compound having an abrasive particle concentration of 1%, a concentration of an ammonium polyacrylate added as an additive to the abrasive particle mixed liquid A of 0.007%, a concentration of an ammonium polyacrylate added from the additive liquid B of 0.145%, a total concentration of an ammonium polyacrylate added as additives of 0.152%, a malonic acid concentration of 0.083% and a pH of 5.06.

### EXAMPLE 2

An additive liquid C was prepared in the same manner as the preparation of the additive liquid B in Example 1 except that instead of malonic acid, adipic acid (pKa₂=5.03) was used, and the concentration of adipic acid was adjusted to be 0.272%. This additive liquid C and the abrasive particle mixed liquid A prepared in the same manner as in Example 1 were mixed in a mass ratio of 1:1 with stirring to prepare a polishing compound having an abrasive particle concentration of 1%, an adipic acid concentration of 0.136% and a pH of 4.90.

### EXAMPLE 3

An additive liquid D was prepared in the same manner as the preparation of the additive liquid B in Example 1 except that instead of malonic acid, succinic acid (pKa₂=5.24) was used, and the concentration of succinic acid was adjusted to be 0.198%. This additive liquid D and the abrasive particle mixed liquid A prepared in the same manner as in Example 1 were mixed in a mass ratio of 1:1 with stirring to obtain a polishing compound having an abrasive particle concentration of 1%, a succinic acid concentration of 0.099% and a pH of 5.06.

### EXAMPLE 4 (Comparative Example)

An additive liquid E was prepared in the same manner as the preparation of the additive liquid B in Example 1 except that instead of malonic acid, tartaric acid (pKa₂=4.37) was used, the concentration of tartaric acid was adjusted to be 0.100%, and the concentration of an ammonium polyacrylate was changed to 0.17%. This additive liquid E and the abrasive particle mixed liquid A prepared in the same manner as in Example 1 were mixed in a mass ratio of 1:1 with stirring to prepare a polishing compound having an abrasive particle concentration of 1%, a tartaric acid concentration of 0.050% and a pH of 5.03.

### EXAMPLE 5 (Comparative Example)

An additive liquid F was prepared in the same manner as the preparation of the additive liquid B in Example 1 except that instead of malonic acid, nitric acid was used, the concentration of nitric acid was adjusted to be 0.082%, and the concentration of an ammonium polyacrylate was changed to 0.17%. This additive liquid F and the abrasive particle mixed liquid A prepared in the same manner as in Example 1 were mixed in a mass ratio of 1:1 with stirring to prepare a polishing compound having an abrasive particle concentration of 1%, a nitric acid concentration of 0.041% and a pH of 5.03.

With respect to each of the above Examples, the composition, pH, average particle diameter (µm) of abrasive particles, of the polishing compound, and the time for agglomeration and sedimentation of the polishing compound are shown in Table 1. In each of Examples 1 to 5, the average particle diameter of the final polishing compound was 0.19 µm like the abrasive particle mixed liquid A. Namely, no progress in agglomeration of particles was observed by the mixing with the additive liquids B to F. These polishing compounds were left to stand to evaluate the dispersion stability, whereby even upon expiration of 10 days, no agglomeration or sedimentation was observed, and the dispersion was maintained. Such a dispersed state was at an equal level as the abrasive particle mixed liquid A having no additive incorporated. Even when the polishing compound was left to stand for 10 days by the above dispersion stability evaluation method, no supernatant layer appeared, and the dispersibility was excellent.

**TABLE 1**

| Example No. | Cerium oxide concentration (%) | pH | Average particle diameter | Time for agglomeration and sedimentation |
|---|---|---|---|---|
| 1 | 1.000 | 5.06 | 0.19 | >10 days |
| 2 | 1.000 | 4.90 | 0.19 | >10 days |
| 3 | 1.000 | 5.06 | 0.19 | >10 days |
| 4 | 1.000 | 5.03 | 0.19 | >10 days |
| 5 | 1.000 | 5.03 | 0.19 | >10 days |

Now, the results of evaluation of the polishing characteristics when the respective polishing compounds of Examples 1 to 5 were used, are shown in Table 2. Here, the results having the polishing characteristics evaluated when the ammonia concentration became 10 (ppm) or 20 (ppm) by gradually adding 1.0% aqueous ammonia to each of the polishing compounds of Examples 1 to 5, are also shown in Table 2.

**TABLE 2**

| Example No. | Ammonia concentration (ppm) | pH | Removal rate (nm/min) |
|---|---|---|---|
| 1 | 0 | 5.06 | 302 |
| | 10 | 5.13 | 295 |
| | 20 | 5.20 | 301 |
| 2 | 0 | 4.90 | 259 |
| | 10 | 4.94 | 258 |
| | 20 | 4.99 | 266 |
| 3 | 0 | 5.06 | 319 |
| | 10 | 5.12 | 318 |
| | 20 | 5.17 | 324 |
| 4 | 0 | 5.03 | 274 |
| | 10 | 5.22 | 309 |
| | 20 | 5.43 | 353 |
| 5 | 0 | 5.03 | 249 |
| | 10 | 5.30 | 295 |
| | 20 | 5.55 | 358 |

Further, the interrelation between the ammonia concentration (ppm) in each of the polishing compounds of Examples 1 to 5 and the removal rate is shown in Fig. 4.

From the results in Table 2 and Fig. 4, it is evident that the polishing compounds of Examples 1 to 3 as working examples of the present invention have the same levels of dispersion stability and removal rate as the polishing compositions of Examples 4 and 5 and exhibit stabilized polishing characteristics even in the presence of ammonia.

### INDUSTRIAL APPLICABILITY

The semiconductor polishing compound of the present invention is not only excellent in dispersion stability and removal rate but also capable of providing stabilized polishing characteristics even in the presence of ammonia, and thus, it is particularly effective for a STI process comprising a multistage process.

The entire disclosure of Japanese Patent Application No. 2005-165768 filed on June 6, 2005 including specification, claims, drawings and summary is incorporated herein by reference in its entirety.

## Claims

1. A semiconductor polishing compound which is a polishing compound for chemical mechanical polishing to polish a surface to be polished in the production of a semiconductor circuit device, said polishing compound comprising cerium oxide abrasive particles, water and a dicarboxylic acid represented by the formula 1:
HOOC(CH₂)ₙCOOH Formula 1
wherein n is an integer of from 1 to 4, and the pH of said polishing compound at 25°C being within a range of from 3.5 to 6.

2. The semiconductor polishing compound according to Claim 1, wherein the pH is within a range of from 4 to 6.

3. The semiconductor polishing compound according to Claim 1 or 2, wherein the absolute value of the difference between the pKa value of said dicarboxylic acid and said pH is at most 1.0.

4. The semiconductor polishing compound according to any one of Claims 1 to 3, wherein the dicarboxylic acid is at least one member selected from the group consisting of malonic acid, succinic acid and adipic acid.

5. The semiconductor polishing compound according to any one of Claims 1 to 4, wherein the concentration of the dicarboxylic acid is from 0.01 to 0.5 mass%.

6. The semiconductor polishing compound according to any one of Claims 1 to 5, wherein the surface to be polished is made of silicon dioxide.

7. The semiconductor polishing compound according to any one of Claims 1 to 6, which contains at least one additive selected from the group consisting of a water-soluble organic polymer and an anionic surfactant.

8. The semiconductor polishing compound according to Claim 7, wherein the water-soluble organic polymer is a polyacrylic acid or an ammonium polyacrylate.
